## Europäisches Patentamt

## European Patent Office

## Office européen des brevets

(11) Numéro de publication: **0 091 870 B1**

(12) **FASCICULE DE BREVET EUROPEEN**

(45) Date de publication du fascicule du brevet: **29.01.86**

(51) Int. Cl.⁴: **H 01 L 21/90,** H 01 L 21/60, H 01 L 23/28

(21) Numéro de dépôt: **83400709.8**

(22) Date de dépôt: **07.04.83**

(54) **Procédé de positionnement d'une ligne d'interconnexion sur un trou de contact électrique d'un circuit intégré.**

(30) Priorité: **14.04.82 FR 8206409**

(43) Date de publication de la demande:
**19.10.83 Bulletin 83/42**

(45) Mention de la délivrance du brevet:
**29.01.86 Bulletin 86/5**

(84) Etats contractants désignés:
**CH DE GB IT LI NL**

(56) Documents cités:
**DE - A - 2 047 799
DE - A - 2 730 819
FR - A - 2 321 190
FR - A - 2 428 915
US - A - 4 185 294**

(73) Titulaire: **COMMISSARIAT A L'ENERGIE ATOMIQUE
Etablissement de Caractère Scientifique Technique et
Industriel, 31/33, rue de la Fédération, F-75015 Paris (FR)**

(72) Inventeur: **Jeuch, Pierre, 49, Avenue Louis Armand,
F-38170 Seyssins (FR)**

(74) Mandataire: **Mongrédien, André et al, c/o
BREVATOME 25, rue de Ponthieu, F-75008 Paris (FR)**

ACTORUM AG

## Description

La présente invention a pour objet un procédé de positionnement d'une ligne d'interconnexion sur un trou de contact électrique d'un circuit intégré. Ce procédé de positionnement est utilisable, en particulier, dans les procédés de fabrication de circuits intégrés MOS (métal-oxyde-semiconducteur).

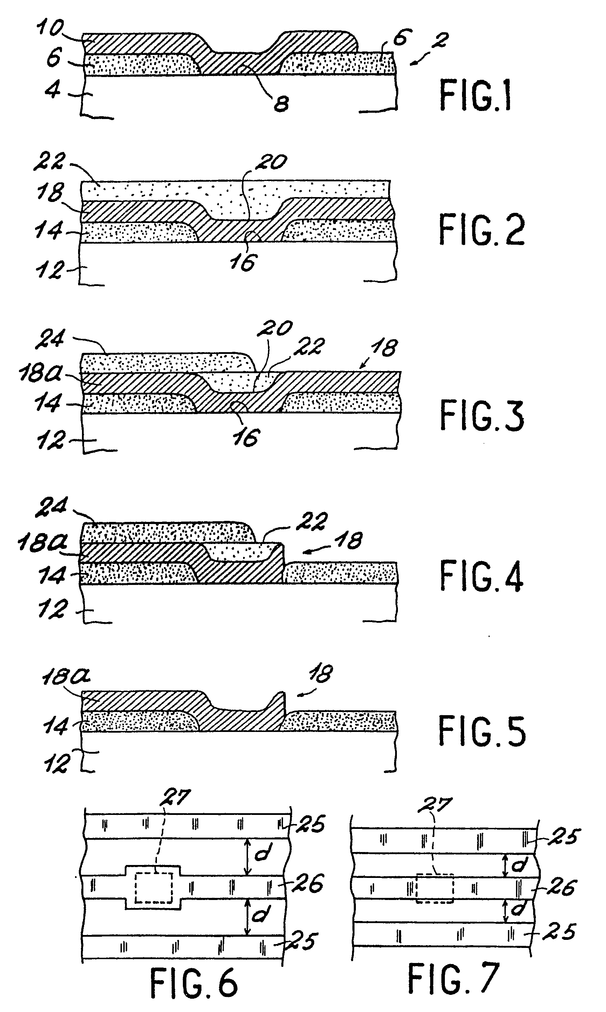

Sur la figure 1, on a représenté, en coupe, selon l'art antérieur, le positionnement d'une ligne d'interconnexion sur un trou de contact électrique d'un circuit intégré. Le circuit intégré, portant la référence générale 2, comprend une zone active 4, semiconductrice dopée, correspondant par exemple à la source ou au drain d'un transistor MOS, devant être connectée électriquement à une autre zone active (non représentée) du circuit intégré. Cette zone active 4 est recouverte d'une couche d'oxyde 6 dans laquelle on réalise le trou de contact électrique 8 de cette zone active 4, en gravant la couche d'oxyde par attaque chimique à travers un masque approprié disposé sur cette couche. L'interconnexion de la zone active 4 et de l'autre zone active du circuit intégré est réalisée en recouvrant l'ensemble du circuit intégré d'une couche conductrice 10 puis en gravant cette couche conductrice par attaque chimique à travers un masque approprié disposé sur cette couche conductrice.

Pour éviter de graver le matériau (silicium) de la zone active 4 du circuit intégré 2 lors de la gravure de la ligne d'interconnexion dans la couche conductrice 10, il est nécessaire que cette dernière recouvre non seulement le trou de contact électrique 8 mais aussi une bonne partie de la couche d'oxyde 6, située de part et d'autre du trou de contact. Malheureusement, le fait que la couche conductrice 10 déborde du trou de contact 8, limite la densité d'intégration de ce circuit intégré.

La présente invention a justement pour objet un procédé de positionnement d'une ligne d'interconnexion sur un trou de contact électrique d'un circuit intégré permettant de remédier à cet inconvénient. Ce procédé de positionnement permet en particulier d'augmenter la densité d'intégration des circuits intégrés de plus de 20% dans certains cas par rapport aux procédés de positionnement de l'art antérieur.

De façon plus précise, l'invention a pour objet un procédé de positionnement d'une ligne d'interconnexion sur un trou de contact électrique réalisé dans une couche isolante recouvrant une zone active d'un circuit intégré, comprenant les étapes successives suivantes:

— dépôt sur l'ensemble du circuit intégré d'une couche conductrice d'épaisseur constante dans laquelle sera réalisée la ligne d'interconnexion,

— dépôt sur la couche conductrice d'une couche d'isolant effaçant le relief de celle-ci et présentant une surface plane,

— réalisation d'une gravure de la couche d'isolant afin de ne laisser de l'isolant qu'à l'emplacement du trou de contact électrique,

— dépôt d'une couche de résine sur le circuit intégré de façon à masquer la ligne d'interconnexion à réaliser,

— réalisation d'une gravure de la partie de la couche conductrice dépourvue à la fois de résine et de la couche d'isolant restante, et

— élimination de la couche d'isolant restante et de la couche de résine.

Ce procédé permet d'éviter tout débordement inutile de la couche conductrice en dehors des trous de contact électrique permettant ainsi d'augmenter l'intégration du circuit intégré.

Selon un mode préféré de mise en oeuvre du procédé selon l'invention, la couche d'isolant est une couche de résine.

Selon un autre mode préféré de mise en oeuvre de l'invention, on réalise après le dépôt de la couche d'isolant un traitement thermique de celle-ci à une température telle que ladite couche flue afin d'améliorer la planéité de sa surface.

Selon un mode de mise en oeuvre avantageux de l'invention, la gravure de la couche d'isolant est une gravure sèche utilisant un plasma d'oxygène.

D'autres caractéristiques et avantages de l'invention ressortiront mieux de la description qui va suivre, donnée à titre illustratif mais nullement limitatif, en référence aux figures annexées, sur lesquelles:

— la figure 1, déjà décrite, représente le positionnement d'une ligne d'interconnexion au niveau d'un trou de contact électrique d'un circuit intégré, selon l'art antérieur,

— les figures 2 à 5 représentent, schématiquement, les différentes étapes du procédé de positionnement, conformément à l'invention, et

— les figures 6 et 7 représentent une disposition type du masque définissant la ligne d'interconnexion, respectivement, selon l'art antérieur et selon l'invention.

Sur la figure 2, on a représenté une partie d'un circuit intégré comprenant une zone active 12, semiconductrice dopée, correspondant par exemple à la source ou au drain d'un transistor MOS que l'on veut connecter électriquement à une autre zone active (non représentée) du circuit intégré. De façon classique, cette zone active 12 est recouverte d'une couche isolante 14 généralement réalisée en silice pouvant contenir 5 à 10% de phosphore. Cette couche de silice présente par exemple une épaisseur de 0,8 μm. Cette couche de silice 14 est ensuite gravée, en utilisant un masque de résine réalisé par photolithographie sur cette couche, par exemple par une attaque chimique (HF dilué) de façon à réaliser le trou de contact électrique 16 de la zone active 12.

Après réalisation du trou de contact électrique 16, on dépose de façon connue, par exemple par la technique de dépôt par pulvérisation magnétron sur l'ensemble du circuit intégré une couche conductrice 18, réalisée de préférence en aluminium. Cette couche conductrice 18 qui présente une épaisseur constante par exemple voisine de 1 μm, présente un profil dépendant des couches sous-jacentes; elle présente en particulier un creux 20 au niveau du trou de contact électrique 16.

Selon un mode préféré de mise en oeuvre de l'invention, on dépose de façon classique une couche d'isolant 22 sur l'ensemble de la couche conductrice 18 de façon qu'elle présente une surface plane. Cette couche d'isolant est réalisée de préférence en résine, telle que celles utilisées usuellement en photolithographie. Dans le cas d'une couche d'isolant réalisée en résine, celle-ci pourra être déposée par centrifugation selon la technique usuellement employée pour déposer les résines photosensibles dans les opérations de photolithographie (procédé dit «de la tournette»). Selon la viscosité de la résine utilisée, on procèdera avantageusement à un traitement thermique, après dépôt de la résine à une température permettant d'obtenir une surface aussi plane que possible grâce à un fluage de cette couche de résine 22.

Une résine photosensible pourra être par exemple chauffée à une température de 150 à 200°C.

L'étape suivante du procédé de positionnement consiste à réaliser une gravure de la couche d'isolant 22 notamment en résine de façon à ne laisser de l'isolant qu'à l'emplacement du trou de contact électrique 16, c'est-à-dire, dans la région en creux 20 de la couche conductrice 18, comme représenté sur la figure 3. Cette gravure peut être réalisée par exemple à l'aide d'un procédé de gravure sèche utilisant un plasma d'oxygène.

Après gravure de la couche de résine 22, on dépose (couchage) une seconde couche de résine photosensible 24 dans laquelle on réalise l'image des interconnexions à réaliser selon les procédés classiques de la photolithographie, c'est-à-dire masquage de la ligne d'interconnexion portant la référence 18a.

Comme représenté sur la figure 4, l'étape suivante du procédé de positionnement consiste à graver la partie de la couche conductrice 18 dépourvue à la fois de la couche de résine 24 et des résidus de la couche de résine 22, les couches de résine 24 et 22 servant de masque à ladite gravure. Cette gravure peut être réalisée de façon isotrope par une simple attaque chimique dans une solution contenant de l'acide phosphorique $H_3PO_4$, dans le cas d'une couche conductrice 18 réalisée en aluminium. Dans le cas de dimensions très petites, on utilisera, de préférence, un procédé de gravure anisotrope utilisant un plasma composé par exemple des composés tels que le $CCl_4$.

La dernière étape du procédé consiste à éliminer les couches de résine 24 et 22 restantes, en utilisant, par exemple, un plasma d'oxygène. La structure obtenue est représentée sur la figure 5.

Le procédé de positionnement décrit précédemment permet de ne garder de la couche conductrice 18, que la région située dans le trou de contact électrique 16, de la zone active 12, ainsi que la région 18a correspondant à la ligne d'interconnexion servant à connecter cette zone active 12 avec une autre zone active du circuit intégré. Le fait de réduire au minimum la couche conductrice, permet de réaliser, par rapport aux procédés de positionnement de l'art antérieur, un gain significatif sur la densité d'intégration du circuit intégré.

Ce gain est illustré par les figures 6 et 7 représentant une disposition typique du masque définissant la ligne d'interconnexion par rapport à celui définissant un trou de contact, selon l'art antérieur pour la figure 6 et selon l'invention pour la figure 7. Le procédé décrit ci-dessus permet de réduire la distance _d_ des lignes d'interconnexion telles que 25, voisines de la ligne 26 qui réalise la connexion du trou de contact électrique 27.

## Revendications

1. Procédé de positionnement d'une ligne d'interconnexion sur un trou de contact électrique (16) réalisé dans une couche isolante (14) recouvrant une zone active (12) d'un circuit intégré, comprenant les étapes successives suivantes:
— dépôt sur l'ensemble du circuit intégré d'une couche conductrice (18) d'épaisseur constante, dans laquelle sera réalisée la ligne d'interconnexion (18a),
— dépôt sur la couche conductrice (18) d'une couche d'isolant (22) effaçant le relief de celle-ci et présentant une surface plane,
— réalisation d'une gravure de la couche d'isolant (22), afin de ne laisser de l'isolant qu'à l'emplacement du trou de contact électrique (16),
— dépôt d'une couche de résine (24) sur le circuit intégré de façon à masquer la ligne d'interconnexion (18a) à réaliser,
— réalisation d'une gravure de la partie de la couche conductrice (18) dépourvue à la fois de résine (24) et de la couche d'isolant (22) restante, et
— élimination de la couche d'isolant (22) restante et de la couche de résine (24).

2. Procédé selon la revendication 1, caractérisé en ce que, la couche d'isolant (22) est une couche de résine.

3. Procédé selon l'une quelconque des revendications 1 et 2, caractérisé en ce que l'on réalise après le dépôt de la couche d'isolant (22) un traitement thermique de celle-ci à une température permettant de faire fluer ladite couche pour améliorer la planéité de sa surface.

4. Procédé selon l'une quelconque des revendications 1 à 3, caractérisé en ce que la gravure de la couche d'isolant (22) est une gravure sèche utilisant un plasma d'oxygène.

5. Procédé selon l'une quelconque des revendications 1 à 4, caractérisé en ce que la gravure de la couche conductrice (18) est une gravure chimique isotrope.

6. Procédé selon l'une quelconque des revendications 1 et 4, caractérisé en ce que la gravure de la couche conductrice (18) est une gravure anisotrope utilisant un plasma.

## Patentansprüche

1. Verfahren zum Positionieren eines Zwischenverbindungsleiters über einem elektrischen Kontaktloch (16) eines integrierten Schaltkreises, welches in einer einen aktiven Bereich (12) überdeckenden Isolierschicht (14) ausgebildet ist, wobei das Verfahren die folgenden Schritte umfasst:
— Aufbringen einer leitenden Schicht (18) konstanter Dicke auf dem gesamten integrierten Schaltkreis, in der der Zwischenverbindungsleiter (18a) ausgebildet wird,

— Aufbringen einer Isolierschicht (22) auf der leitenden Schicht (19), die deren Relief ausgleicht und eine ebene Oberfläche aufweist,

— Durchführen eines Ätzvorganges an der Isolierschicht (22), damit eine Isolierung nur an der Stelle des elektrischen Kontaktloches (16) bleibt,

— Aufbringen einer Harzschicht (24) auf dem integrierten Schaltkreis derart, dass die auszubildende Zwischenverbindungleitung (18a) maskiert wird,

— Durchführung eines Ätzvorganges an dem Teil der leitenden Schicht (18) von der das Harz (24) und auch die verbliebene Isolierschicht (22) entfernt ist, und

— Entfernen der verbliebenen Isolierschicht (22) und der Harzschicht (24).

2. Verfahren nach Anspruch 1, dadurch gekennzeichnet, dass die Isolierschicht (22) eine Harzschicht ist.

3. Verfahren nach Anspruch 1 oder 2, dadurch gekennzeichnet, dass man nach dem Aufbringen der Isolierschicht (22) eine Wärmebehandlung derselben bei einer Temperatur durchführt, die diese Schicht fliessen lässt, um die Ebenheit ihrer Oberfläche zu verbessern.

4. Verfahren nach einem der Ansprüche 1 bis 3, dadurch gekennzeichnet, dass das Ätzen der Isolierschicht (22) ein trockenes Ätzen unter Verwendung eines Sauerstoffplasmas ist.

5. Verfahren nach einem der Ansprüche 1 bis 4, dadurch gekennzeichnet, dass das Ätzen der leitenden Schicht (18) ein chemisches isotropes Ätzen ist.

6. Verfahren nach einem der Ansprüche 1 bis 4, dadurch gekennzeichnet, dass das Ätzen der leitenden Schicht (18) ein anisotropes Ätzen unter Verwendung eines Plasmas ist.

**Claims**

1. Process for the positioning of an interconnection line on an electrical contact hole (16) formed in an insulating layer (14) covering an active zone (12) of an integrated circuit comprising the following successive steps:

— deposition on the integrated circuit assembly of a conductive layer (18) of constant thickness, within which the interconnection line (18a) is formed,

— deposition on the conductive layer (18) of an insulating layer (22) removing surface irregularities and presenting a flat surface,

— etching of the insulating layer (22) to leave the insulation only at the electrical contact hole (16),

— deposition of a resin layer (24) on the integrated circuit whereby to mask the interconnection line (18a) to be formed,

— etching the portion of the conductive layer (18) which has neither resin (24) or residual insulating layer (22), and

— elimination of the residual insulation layer (22) and the resin layer (24).

2. Process according to claim 1, characterised in that the insulation layer (22) is a resin layer.

3. Process according to either of claims 1 and 2, characterised in that after deposition of the insulating layer (22) it is subjected to heat treatment at a temperature producing fluidity of said layer to improve the flatness of its surface.

4. Process according to any one of claims 1 to 3, characterised in that etching of the insulation layer (22) is dry etching employing oxygen plasma.

5. Process according to any one of claims 1 to 4, characterised in that etching of the conductive layer (18) is isotropic chemical etching.

6. Process according to either of claims 1 and 4, characterised in that etching of the conductive layer (18) is anisotropic etching employing a plasma.

0 091 870

FIG.1

FIG.2

FIG.3

FIG.4

FIG.5

FIG.6

FIG.7